Europäisches Patentamt

European Patent Office

Office européen des brevets

(11) Numéro de publication: **0 241 368**
**A1**

## (12) DEMANDE DE BREVET EUROPEEN

(21) Numéro de dépôt: **87400763.6**

(22) Date de dépôt: **06.04.87**

(51) Int. Cl.4: **G 06 F 15/60**
**G 06 G 7/63**

(30) Priorité: **10.04.86 FR 8605141**

(43) Date de publication de la demande:
**14.10.87   Bulletin   87/42**

(84) Etats contractants désignés:
**BE CH DE ES GB IT LI NL SE**

(71) Demandeur: **ELECTRICITE DE FRANCE Service National
2, rue Louis Murat
F-75008 Paris  (FR)**

(72) Inventeur: **Benejean, Richard
2 Mail des Catalpas
F-78180 Montigny le Bretonneux  (FR)**

(74) Mandataire: **Poius, Camille et al
c/o Cabinet Lavoix 2, Place d'Estienne d'Orves
F-75441 Paris Cedex 09  (FR)**

(54) Procédé et dispositif de simulation d'une machine électrique synchrone.

(57) Ce procédé consiste à mesurer des paramètres physiques particuliers choisis d'une machine tournante synchrone, à combiner ces paramètres avec des variables définissant le régime nominal de la machine, à obtenir à partir desdits paramètres physiques et desdites variables un jeu de coefficients des première matrices (A,B,C) de représentation d'état continu de la machine et à obtenir à partir de ces matrices un système d'équations d'état continu de la machine :
$d\,/X(t)/\,/dt = A.X.\,(t) + B.U.(t)$
$Y(t) = C.X(t)$
dans lequel
$X(t)$ est le vecteur d'état du système
$U(t)$ est le vecteur d'entrée du système
$Y(t)$ est le vecteur de sortie du système.

EP 0 241 368 A1

## Description

Procédé et dispositif de simulation d'une machine électrique synchrone.

La présente invention est relative aux simulateurs de machines électriques et se rapporte plus particulièrement à un simulateur d'une machine synchrone par microprocesseur.

On connait des simulateurs de machines synchrones mettant en oeuvre un calculateur analogique et des modèles de champ magnétique du stator, du rotor, de l'entrefer entre pôles, des transformateurs de liaison entre le calculateur analogique et les modèles précités et des blocs d'imitation de la rotation du rotor.

Les simulateurs de ce type sont de construction relativement complexe et ne sont adaptés à la simulation que d'un seul type de machine.

Par conséquent, compte tenu de la diversité des machines synchrones à étudier, la nécessité de réaliser un simulateur par type de machine rend cette technique d'un prix de revient prohibitif.

L'invention vise à remédier aux inconvénients des simulateurs connus en créant un procédé de simulation de machines synchrones qui soit adapté au calcul numérique et qui permette de ce fait d'assurer la simulation d'une machine synchrone de type quelconque, sans nécessiter de modification de la structure du simulateur.

Elle a également pour but d'assurer la simulation d'un régulateur de machine synchrone connectée au réseau de transport électrique afin de permettre :
- la mise au point et le test du logiciel des nouvelles régulations de tension des groupes turbo-alternateurs;
- la mise en service sur des sites en permettant l'essai immédiat de la capacité du fonctionnement du régulateur associé avant le couplage au système réel.

Elle a donc pour objet un procédé de simulation d'une machine électrique synchrone, caractérisé en ce qu'il consiste à mesurer des paramètres physiques particuliers choisis d'une machine tournante synchrone, à combiner ces paramètres avec des variables définissant le régime nominal de la machine, à obtenir à partir desdits paramètres physiques et desdites variables un jeu de coefficients des première matrices de représentation d'état continu de la machine et à obtenir à partir de ces matrices un système d'équations d'état continu de la machine :

$$d\ /X(t)/\ /dt = A.X.\ (t) + B.U.(t)$$
$$Y(t) = C.X(t)$$

dans lequel

$X(t)$ est le vecteur d'état du système, dont la première composante $\Delta V(t)/V_n$ représente à l'instant t les variations relatives de la tension du stator, dont la deuxième composante $\Delta\Omega(t)$ représente les variations de la vitesse de la machine synchrone et dont la troisième composante $\Delta P_e(t)/P_n$ représente les variations relatives de la puissance electrique;

$U(t)$ est le vecteur d'entrée du systeme dont la première composante $\Delta V_{ex}(t)/V_{exn}$ représente les variations relatives de la tension d'excitation de la machine, et dont la deuxième composante $\Delta P_m(t)/P_{mn}$ représente la variation relative de la puissance mécanique appliquée à la machine;

$Y(t)$ est le vecteur de sortie du système, dont la première composante $\Delta\delta'(t)$ représente les variations d'angle interne total entre la tension du réseau et la f.e.m. de la machine, dont la deuxième composante $\Delta Q_e(t)/Q_n$ représente les variations relatives de la puissance réactive dont la troisième composante $\Delta I(t)/I_n$ représente les variations relatives du courant du stator et dont les quatrième et cinquième composantes $\Delta\delta(t)$ et $\Delta\Psi(t)$ représentent respectivement les variations de l'angle interne entre la tension du stator et la f.e.m. de la machine et les variations de l'angle de transport entre la tension du stator et la tension du réseau.

L'invention sera mieux comprise à l'aide de la description qui va suivre, donnée uniquement à titre d'exemple et faite en se référant aux dessins annexés, sur lesquels :
- la Fig.1 est un diagramme de fonctionnement d'une machine synchrone connectée au réseau de transport;
- la Fig.2 est un diagramme de fonctionnement d'une machine synchrone découplée du réseau de transport électrique;
- la Fig.3 est une représentation vectorielle en grandeurs réduites du diagramme de la Fig.2;
- la Fig.4 est un schéma électrique d'un simulateur analogique destiné à la mise en oeuvre du procédé de l'invention; et
- les Fig.5 à 7 montrent des organigrammes de mise en oeuvre du procédé de simulation suivant l'invention.

Dans ce qui va suivre, l'invention est considérée comme étant appliquée à la simulation d'un groupe turbo-alternateur.

La détermination des paramètres physiques de la machine synchrone qui constitue la première étape du procédé suivant l'invention est assurée par des mesures directes ou par calcul.

Ces données sont généralement fournies par le constructeur de la machine.

Les paramètres physiques d'une machine électrique tournante sont les suivants :

$R_a$ résistance de l'induit par phase

$R_f$ résistance de l'inducteur par phase

$R$ partie réelle de l'impédance de ligne vue des bornes de la machine (transformateur de tranche + réseau de transport)

$M_{af}$ coefficient de mutuelle inductance entre l'inducteur et l'induit

$L_d, L_q$ inductances synchrones longitudinale et transversale respectivement

$L_f$ inductance propre du circuit inducteur

$L$ inductance propre de la ligne vue des bornes de la machine (transformateur de tranche + réseau de transport)

$X_{af} = M_{af}\omega$ réactance associée à la mutuelle inductance $M_{af}$

$X_d = L_d\omega$ réactance synchrone longitudinale

$X_q = L_q\omega$ réactance synchrone transversale

$X = L\omega$ partie imaginaire de l'impédance de ligne vue des bornes de la machine (réactance totale : transformateur de tranche + réseau de transport)

$X_t$ partie imaginaire de l'impédance du transformateur de tranche

$X_L$ partie imaginaire de l'impédance de la ligne de transport

$X_{cc}$ impédance de court-circuit du réseau de transport dit "infini"

$X_s$ réactance de fuite du stator

$J$ moment d'inertie des masses tournantes du groupe turbo-alternateur

$T_L$ temps de lancé du groupe turbo-alternateur

$\tau'_{do}$ constante de temps transitoire longitudinale à circuit ouvert

$\tau'_d$ constante de temps transitoire longitudinale en court-circuit

$\tau''_{do}$ constante de temps subtransitoire longitudinale à circuit ouvert

$\tau''_d$ constante de temps subtransitoire longitudinale en court-circuit

$\tau''_{qo}$ constante de temps subtransitoire transversale à circuit ouvert

$\tau''_q$ constante de temps subtransitoire transversale en court-circuit

$\tau_{kd}$ constante de temps du circuit magnétique en court-circuit axée fictivement sur l'axe direct

$X'_d, X'_q$ réactances transitoires longitudinale et transversale respectivement

$X''_d, X''_q$ réactance subtransitoires longitudinale et transversale respectivement

Les variables de fonctionnement de la machine sont les suivantes :

$V$ valeur efficace par phase de la tension au stator de l'alternateur

$V_d, V_q$ composantes selon l'axe direct et l'axe en quadrature respectivement

$V_{res}$ tension de phase du reseau de transport d'énergie électrique

$V_{rd}, V_{rq}$ composantes selon l'axe direct et l'axe en quadrature respectivement

$V_{ex}$ tension d'excitation de l'alternateur

$I$ valeur efficace du courant de phase au stator de l'alternateur

$I_d, I_q$ composantes selon l'axe direct et l'axe en quadrature respectivement

$I_{ex}$ courant inducteur de l'alternateur

$P_e$ puissance électrique active fournie par l'alternateur au réseau de transport

$Q_e$ puissance réactive délivrée par l'alternateur

$S$ puissance apparente de la machine

$P_m$ puissance mécanique

$C_m$ couple moteur disponible sur l'arbre du groupe turbo-alternateur

$C_e$ couple électrique délivré par l'alternateur

$\varnothing_d, \varnothing_q$ flux d'enroulement d'axes direct et en quadrature respectivement

$\varnothing_f$ flux d'enroulement de l'inducteur

$E$ valeur efficace de la force électromotrice induite dans la machine (f.e.m)

$\omega'$ vitesse de rotation du rotor supposé bipolaire

$\omega$ pulsation du réseau de transport électrique (50Hz = 100 $\pi$ rd/s)

$\Omega$ vitesse mécanique de l'arbre du groupe turbo-alternateur ($\Omega = \omega'$ pour une machine bipolaire)

$\varphi$ facteur de puissance (angle de déphasage entre I et V)

$\delta$ angle de charge ou angle interne (angle entre V et E)

$\delta'$ angle interne total (angle entre $V_r$ et E)

$\Psi$ angle de transport (angle entre V et $V_r$)

Les significations des indices employés dans la description sont les suivantes :

kd appliqué aux grandeurs caractéristiques des circuits amortisseurs

h appliqué aux grandeurs intervenant en présence d'une composante homopolaire

o utilisé pour définir le régime initial permanent

n utilisé pour définir le régime nominal

Les paramètres physiques choisis pour la mise en oeuvre du procédé sont les suivants :

$T_L$ temps de lancé du groupe turbo-alternateur

$\tau'_d$ constante de temps longitudinale en court-circuit

$\tau'_{do}$ constante de temps transitoire longitudinale à circuit ouvert

$\tau''_d$ constante de temps subtransitoire longitudinale en court-circuit

$X_d = L_d\omega$ réactance synchrone longitudinale

$X_q = L_q\omega$ réactance synchrone transversale

$X''_d$ réactance transitoire longitudinale

$R_a$ résistance de l'induit par phase

$R$ partie réelle de l'impédance de ligne vue des bornes de la machine (transformateur de tranche + réseau de transport)

Les variables définissant le régime nominal de la machine sont les suivantes :

$S_n$ puissance apparente nominale

$U_n$ tension nominale

$\cos \varphi_n$ facteur de puissance nominal

$\omega_n$ pulsation nominale

Le seconde étape du procédé de l'invention consiste en la détermination du régime de fonctionnement courant de la machine.

A cet effet, on choisit quatre parmi les cinq paramètres suivants :

$$V_r = \frac{V_o}{V_n}$$

valeur réduite de la tension au stator de la machine

$$P_r = \frac{P_o}{P_n}$$

valeur réduite de la puissance électrique fournie par la machine

$$Q_r = \frac{Q_o}{Q_n}$$

valeur réduite de la puissance réactive délivrée par la machine

$X_{ligne}$ partie imaginaire de l'impédance de la ligne de transport

$V_{res}$ tension de phase du réseau de transport d'énergie électrique

La troisième étape du procédé de l'invention consiste à calculer les paramètres intermédiaires à partir des relations données dans le tableau suivant :

<u>TABLEAU I</u>

$$\varphi_n = \left[ AN^2 + (1 + BN)^2 \right]^{1/2} + (x_d - x_q) \sin(\delta_n + \varphi_n) \qquad 1$$

$$\sin \delta_n = \left[ AN / AN^2 + (1 + BN)^2 \right]^{1/2} \qquad 2$$

$$\rho_o = \left[ AN'^2 + (HBN')^2 \right]^{1/2} + (x_d - x_q)(P_r / V^2_r)(\cos \varphi_n / \cos \varphi_o) \sin(\delta_o + \varphi_o) \qquad 3$$

$$\sin \delta_o = AN' / \left[ AN^2 + (1 + BN')^2 \right]^{1/2} \qquad 4$$

$$\cos \delta_o = (1 + BN') / \left[ AN'^2 + (1 + BN')^2 \right]^{1/2} \qquad 5$$

$$V_{reso} / V_n = \left[ (V_{rxo}/V_n)^2 + (V_{ryo}/V_n)^2 \right]^{1/2} \qquad 6$$

avec

$$AN = - r_a \sin \varphi_n + x_q \cos \varphi_n \qquad 7$$

$$BN = r_a \cos \varphi_n + x_q \sin \varphi_n \qquad 8$$

$$AN' = - r_a \sin \varphi_o \cdot I_r/V_r + x_q \cos \varphi_o \cdot I_r/V_r \qquad 9$$

$$BN' = r_a \cos \varphi_o \cdot I_r/V_r + x_q \sin \varphi_o \cdot I_r/V_r \qquad 10$$

$$V_{rxo}/V_n = V_r - r \cos \varphi_n \cdot P_r/V_r - x_1 \sin \varphi_n \cdot Q_r/V_r \qquad 11$$

$$V_{ryo}/V_n = r \sin \varphi_n \cdot Q_r/V_r - x_1 \cos \varphi_n \cdot P_r/V_r \qquad 12$$

$$r_a = R_a/Z_n, \quad r = R/Z_n$$

$$x_q = X_q/Z_n, \quad x_d = X_d/Z_n, \quad x_1 = X/Z_n$$

$$Z_n = 3V_n^2/S_n$$

Tous les paramètres définis précédemment et intervenant dans la représentation de la machine synchrone dans l'espace d'état sont calculés en fonction des données physiques :

$T_L$, $\tau'_d$, $\tau'_{do}$, $\tau''_d$, $X_d$, $X_q$, $X''_d$ et du point de fonctionnement retenu donné par les quatre variables : $V_o$, $P_o$, $Q_o$, $X$

Ces calculs sont réalisés à l'aide d'un programme approprié.

A l'aide d'un second algorithme, on détermine ensuite les coefficients composant les matrices A, B et C du modèle d'état simplifié de la machine.

La représentation de la machine synchrone dans l'espace d'état a un double intérêt.

Elle permet en raison de sa simplicité d'aborder l'étude mathématique des nouvelles régulations de tension et elle facilite la réalisation matérielle d'un simulateur de groupe turbo-alternateur.

Les matrices A, B et C sont données par les expressions suivantes :

$$A = \begin{vmatrix} a_{11} & a_{12} & a_{13} \\ 0 & -D & -H \\ a_{31} & a_{32} & a_{33} \end{vmatrix} \quad 13 \qquad B = \begin{vmatrix} b_{11} & 0 \\ 0 & H \\ b_{31} & 0 \end{vmatrix} \quad 14$$

$$C = \begin{vmatrix} c_{11} & 0 & c_{13} \\ c_{21} & 0 & c_{23} \\ c_{31} & 0 & c_{33} \\ c_{41} & 0 & c_{43} \\ c_{51} & 0 & c_{53} \end{vmatrix} \quad 15$$

La matrice A carrée (3x3) est en concordance avec le nombre des grandeurs d'état. Elle est déterminante pour le comportement dynamique du système, en particulier en ce qui concerne les valeurs propres.

Elle est appelée matrice du système ou matrice fondamentale.

La matrice B rectangulaire (3x2) est en concordance avec le nombre des grandeurs d'état (3) et le nombre des grandeurs d'entrée (2).

Par conséquent, cette matrice est appelée matrice d'entrée.

Les éléments $b_{ij}$ de cette matrice donnent la liaison entre les différentes grandeurs d'entrée et les grandeurs d'état.

La matrice C rectangulaire (5x3) est en concordance avec le nombre des grandeurs de sortie (5) et le nombre des grandeurs d'état (3).

Les éléments $C_{ij}$ de cette matrice, appelée matrice de sortie, donnent la liaison entre les grandeurs d'état et les grandeurs de sortie.

Les coefficients $a_{ij}$, $i = 1,3$, $j = 1,3$; $b_{ij}$, $i = 1,3$, $j = 1,2$ et $c_{ij}$ $i = 1,5$, $j = 1,3$ des matrices respectives A, B et C sont donnés dans le tableau suivant :

<u>TABLEAU II</u>

$$a_{11} = \alpha h_3 / \tau h_1 = h_3 a_{31} \qquad a_{31} = \alpha / \tau h_1$$

$$a_{12} = h_1 + \beta h_3 / \tau = h_1 + h_3 a_{32} \qquad a_{32} = \beta / \tau$$

$$a_{13} = - h_3 (1 + \alpha h_3 / h_1) / = h_3 a_{33} \qquad a_{33} = -(1 + \alpha h_3 / h_1) / \tau$$

$$b_{11} = \gamma h_3 / \tau = h_3 b_{31} \qquad b_{31} = \gamma / \tau$$

$$c_{11} = h_1^{-1}$$

$$c_{21} = h_{1Q} h_1^{-1} \qquad c_{13} = - h_3 c_{11}$$

$$c_{31} = h_{1I} h_1^{-1} \qquad c_{23} = h_{3Q} - h_3 c_{21}$$

$$c_{41} = h_1 \delta h_1^{-1} \qquad c_{33} = h_{3I} - h_3 c_{31}$$

$$c_{51} = h_1 \psi h_1^{-1} \qquad c_{43} = h_3 \delta - h_3 c_{41}$$

$$c_{53} = h_3 \psi - h_3 c_{51}$$

Détermination des paramètres intervenant dans la représentation d'état.

a) <u>Expressions générales</u>

Les expressions des paramètres $\alpha$, $\beta$, $\gamma$... intervenant dans les coefficients des matrices A, B et C de la représentation d'état simplifiée de la machine synchrone sont rappelées dans le tableau III.

Les conventions d'écriture adoptées sont les suivantes :

$X = L \omega$ 16

$x_1 = X (p.u.) = X (\Omega)/Z_n$ 17

avec

$Z_n = 3 V^2_n/S_n$ 18

$x = X/X_d$ 2-17 $(x' = X/X_q)$ 19

$x_d = X_d/Z_n$ 2-19 $(x_q = X_q/Z_n)$ 20

$\rho_0 = E_0/V_0$ 2-21 $(\rho_n = E_n/V_n$ 21

La relation (17) définit par convention le passage des valeurs réelles utilisant les unités du système de mesure international (m.s.i), aux valeurs réduites sans dimension exprimées en pourcent (p.u. = per unit).

Les paramètres intervenant dans les coefficients des matrices A, B et C du modèle d'état simplifié de la machine synchrone raccordée à un réseau de transport de puissance infinie sont donnés dans le tableau suivant :

TABLEAU III

$$\alpha = \left(\frac{V_o}{V_n}\right)^2 \frac{1}{x_d \cos\varphi\, n} \left[\frac{(\cos\delta_o(1+x)-x\,\rho_o)(\cos\delta_o(x'-x)+x\,\rho_o)}{x(1+x')} - \frac{\sin^2\delta_o(1+x')(x'-x)}{x(1+x)}\right] \quad 1$$

$$\beta = \left(\frac{V_o}{V_n}\right)^2 \frac{1}{x_d \cos\varphi\, n} \left[\frac{(\cos\delta_o(1+x)-x\,\rho_o)(\cos\delta_o(x'-x)+x\,\rho_o)\,\tau}{x(1+x')} + \right.$$
$$\left. + \frac{\sin^2\delta_o(1+x')(x\,\tau'_{do}-x'\,\tau'_d)}{x(1+x)}\right] \quad 2$$

$$\gamma = \left(\frac{V_o}{V_n}\right) \rho\, n \frac{1}{x_d \cos\varphi\, n} \left[\frac{1+x'}{1+x}\, x\sin\delta_o\right] \quad 3$$

$$\tau = (x\,\tau'_{do} + \tau'_d)/(1+x) \quad 4$$

$$H = \omega_o / T_L \quad 5$$

$$D = H\,\tau''_d\,(V_{res}/V_n)^2 / (x_d \cos\varphi'_N)(x + x''_d/x_d) \quad 6$$

$$h_1 = -\left(\frac{V_o}{V_n}\right) \frac{(x\,\rho_o + \cos\delta_o(x'-x))}{(1+x')^2 \sin\delta_o}(1 + x\cos^2\delta_o + x'\sin^2\delta_o - x\,\rho_o\cos\delta_o) \quad 7$$

$$h_3 = \left(\frac{V_n}{V_o}\right) x_d \cos\varphi\, n \cdot \frac{x}{1+x'} \frac{\cos\delta_o}{\sin\delta_o} \quad 8$$

TABLEAU III suite

$$h_{1Q} = \left(\frac{V_o}{V_n}\right)^2 \frac{1}{x_d \sin\varphi n} \frac{(x\rho_o + \cos\delta_o (x'-x))}{x(1+x')^2 \sin\delta_o} (1 - x^2(\rho_o - \cos\delta_o)^2 - x^2 \sin^2\delta_o) \qquad 9$$

$$h_{3Q} = \frac{\cos\varphi n}{\sin\varphi n} \frac{(\cos\delta_o (1-x) + x\rho_o)}{(1+x')\sin\delta_o} \qquad 10$$

$$h_{11} = \left(\frac{V_o}{V_n}\right) \frac{1}{x_d} \frac{(x\rho_o + \cos\delta_o (x'-x))((1+x')x'\sin^2\delta_o + (1+x)x\cos^2\delta_o +}{x^2(1+x')^2}$$

$$\frac{-x\rho_o \cos\delta_o (1+2x) + x^2\rho_o^2)}{\sqrt{(\rho_o - \cos\delta_o)^2 + (\frac{x'}{x})^2 \sin^2\delta_o}} \qquad 11$$

$$h_{31} = \left(\frac{V_n}{V_o}\right) \frac{\cos\varphi n \ (\rho_o - \cos\delta_o)}{(1+x')\sin\delta_o \sqrt{(\rho_o - \cos\delta_o)^2 + (\frac{x'}{x})^2 \sin^2\delta_o}} \qquad 12$$

$$h_1 = 1 - \frac{(x\rho_o + \cos\delta_o (x'-x))^2}{(1+x')^2} \qquad 13$$

$$h_{3\delta} = -\left(\frac{V_n}{V_o}\right)^2 x_d \cos\varphi n \frac{x}{1+x'} \qquad 14$$

$$h_{1\psi} = \frac{(x\rho_o = \cos\delta_o (x'-x))^2}{(1+x')^2} \qquad 15$$

$$h_{3\psi} = \left(\frac{V_n}{V_o}\right)^2 x_d \cos\varphi n \frac{x}{1+x'} \qquad 16$$

On notera pour ce type de réseau, l'identité stricte entre la vitesse de rotation du groupe turbo-alternateur en régime d'équilibre $\omega_o$ et la pulsation du réseau de transport électrique .

On notera aussi que pour la détermination du paramètre D, on a supposé l'identité des réactances subtransitoires $X''_d$ et $X''_q$ (ou encore $x''_d$ et $x''_q$) suivant les deux axes longitudinal et transversal.

b) Expressions simplifiées

Dans le cas où les réactances synchrones longitudinale et transversale $X_d$ et $X_q$ sont identiques, les formules établies au tableau III se simplifient avantageusement.

Cette approximation est parfaitement envisageable en pratique, pour de nombreuses machines à pôles lisses. Les expressions simplifiées pour les paramètres ont obtenues simplement en posant l'égalité :
$$x = x'$$
dans les expressions du tableau III.

Les expressions simplifiées obtenues sont données dans le tableau IV ci-après.

**TABLEAU IV**

| HYPOTHESE $X_d = X_q$ | |
|---|---|
| $\alpha = (V_o/V_n)^2 \, \rho_o \, (\cos \delta_o \cdot (1 + x) - x \, \rho_o)/(1 + x) \, x_d \cos \varphi_n =$ | 1 |
| $\beta = \alpha \mathcal{T} + (V_o/V_n)^2 \sin^2 \hat{\delta}_o \cdot (\mathcal{T}'_{do} - \mathcal{T}'_d)/x_d \cos \varphi_n =$ | 2 |
| $\gamma = (V_o/V_n) \, \rho_n \sin \delta_o/x_d \cos \varphi_n = (V_o/V_n) \sin \delta_o/\sin \delta_n =$ | 3 |
| $\mathcal{T} = (x \, \mathcal{T}'_{do} + \mathcal{T}'_d)/(1 + x) =$ | 4 |
| $H = \omega_o/T_L = P_o/J\omega_o =$ | 5 |
| $D = H \mathcal{T}''_d (V_{res_o}/V_n)^2/x_d \cos \varphi_n \cdot (x + x''_d/x_d)$ | 6 |
| $h_1 = -(V_o/V_n) \, x \, \rho_o \, (1 + x - x \, \rho_o \cos \delta_o)/(1 + x)^2 \sin \hat{\delta}_o$ | 7 |
| $h_3 = x_d \cos \varphi_n \cdot x \cos \hat{\delta}_o/(V_o/V_n) \, (1 + x) \sin \hat{\delta}_o$ | 8 |
| $h_{1Q} = -(V_o/V_n)^2 \, x \, \rho_o \left[ 1 - x^2 (1 + \rho_o^2 - 2 \, \rho_o \cos \hat{\delta}_o) \right] /x_d \sin \varphi_n \cdot x \, (1 + x)^2 \sin \delta_o$ | 9 |
| $h_{3Q} = \cos \varphi_n \cdot \left[ (1 - x) \cos \hat{\delta}_o + x \, \rho_o \right] / \sin \varphi_n \, (1 + x) \sin \delta_o$ | 10 |
| $h_{1I} = (V_o/V_n) \, x \, \rho_o \left[ (1 + x) \, x + x \, \rho_o \left[ x \, \rho_o - \cos \delta_o \cdot (1 + 2 x) \right] \right] /$ | |
| $\qquad x_d \, x^2 \, (1 + x)^2 \, (1 + \rho_o - 2 \, \rho_o \cos \delta_o)^{\frac{1}{2}}$ | 11 |
| $h_{3I} = \cos \varphi_n \cdot (\rho_o - \cos \delta_o)/(V_o/V_n) \, (1 + x) \sin \delta_o \, (1 + \rho_o - 2 \, \rho_o \cos \delta_o)^{\frac{1}{2}}$ | 12 |
| $h_{1\delta} = 1 - \left[ x \, \rho_o/(1 + x) \right]^2$ | 13 |
| $h_{3\delta} = -x_d \cos \varphi_n \cdot x/(V_o/V_n)^2 \, (1 + x)$ | 14 |
| $h_{1\Psi} = \left[ x \, \rho_o/(1 + x) \right]^2$ | 15 |
| $h_{3\Psi} = x_d \cos \varphi_n \cdot x/(V_o/V_n)^2 \, (1 + x)$ | 16 |

## c) Rôle des différents paramètres

Les rôles joués par les principaux paramètres donnés au tableau III sont rappelés succinctement ici.

$\alpha$ puissance synchronisante si positif : une augmentation de la tension stator lui est favorable,

$\beta$ puissance synchronisante si positif. Il joue dans ce cas un rôle d'amortisseur vis-à-vis des oscillations électromécaniques. Une augmentation de la tension stator lui est favorable : à puissance électrique élevée, ce coefficient diminue rapidement avec l'augmentation de la réactance totale de liaison et peut même devenir négatif,

$\gamma$ image de l'action d'une variation de tension d'excitation sur la puissance électrique : action d'autant plus importante que la puissance électrique délivrée est élevée,

$\zeta$ constante de temps d'établissement du flux dans la machine synchrone : augmente avec la longueur de ligne,

H mesure l'accélération 'nominale' du groupe turbo-alternateur en $rd/s^2$,

D coefficient d'amortissement : diminue avec la longueur de ligne,

$h_1$ jouera un rôle important dans la régulation de tension stator. Si ce coefficient est négatif, la réinjection de tension créera un couple synchronisant favorable à la stabilité du groupe turbo-alternateur,

$h_3$ traduit l'interaction de l'écart relatif de puissance active sur l'écart relatif de tension.

## Détermination des variables intermédiaires

### a) Intervention des variables auxiliaires.

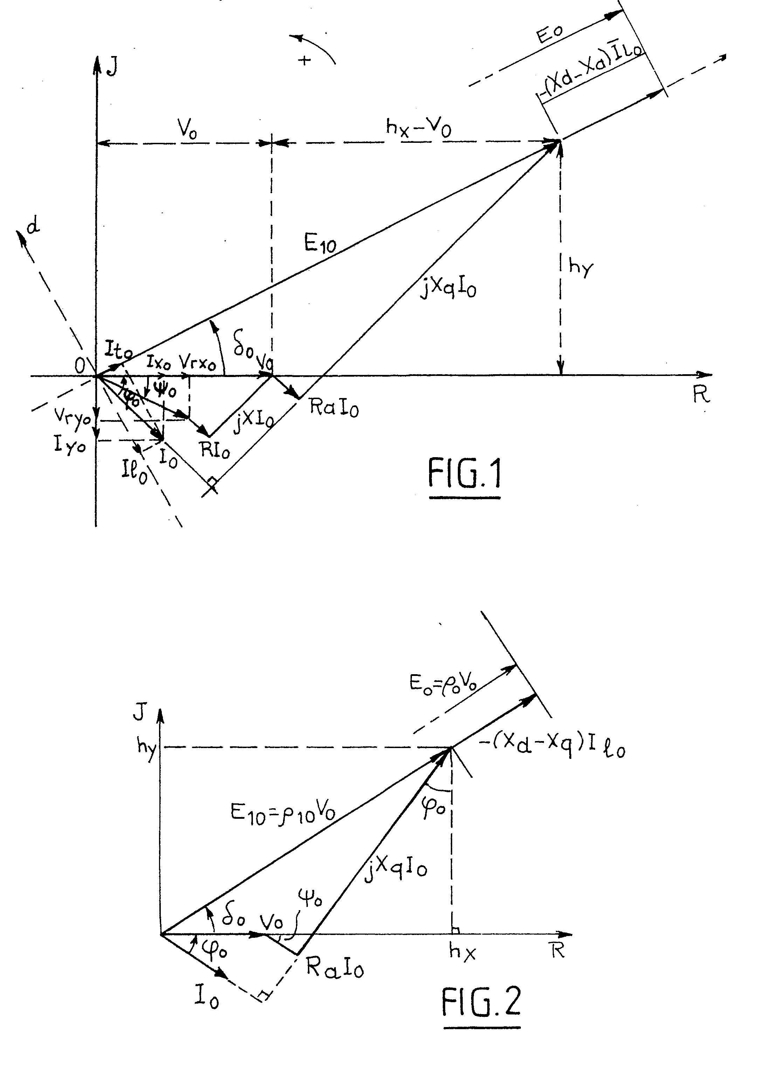

Pour définir entièrement le modèle d'état proposé ci-dessus, il faut en dernier lieu, rechercher les expressions littérales des grandeurs $\rho_o$, $\rho_n$, $\delta_o$, $\delta$ n caractérisant le régime de fonctionnement de la machine synchrone et du rapport $V_{res}/V_n$ définissant l'état du réseau de transport électrique. Ces variables intermédiaires interviennent dans la détermination des paramètres $\alpha$, $\beta$ ..., comme le montrent les tableaux (III) et (IV). Pour cela, il est adopté le diagramme de fonctionnement de la machine synchrone connectée au réseau de transport (ou diagramme de BLONDEL) représenté sur la Fig.1.

### b) Caractéristiques de la machine

### Régime de fonctionnement nominal

Le diagramme de fonctionnement de la machine synchrone découplée du réseau de transport est représenté a la Fig.2.

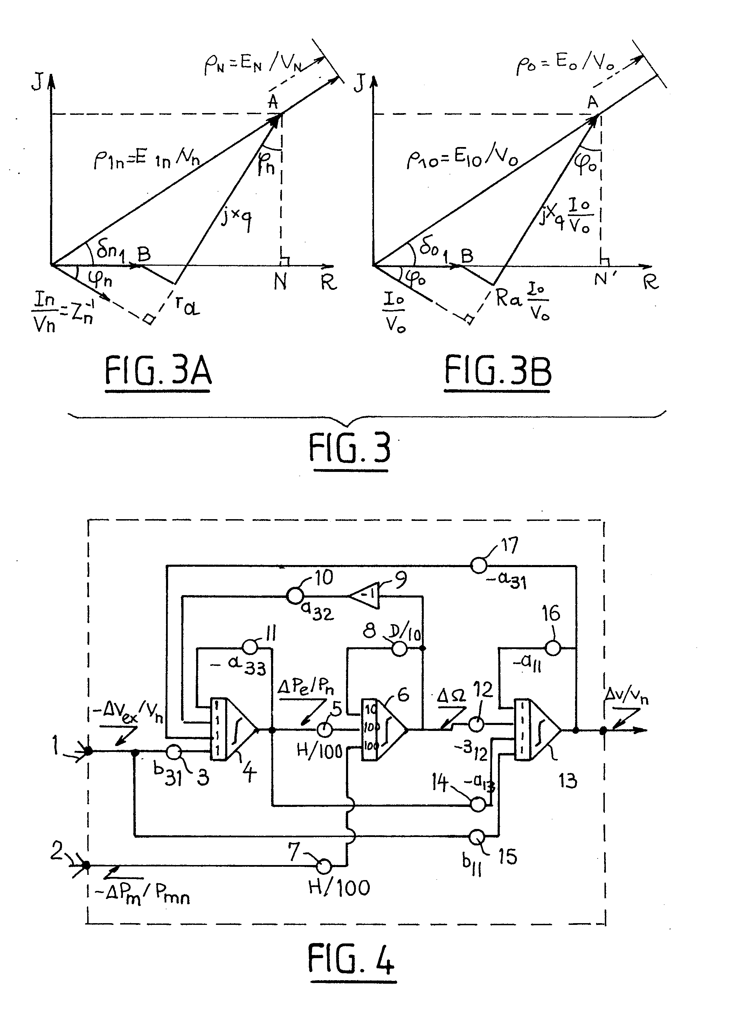

Le diagramme de fonctionnement au régime nominal et en variables reduites est aisement obtenu en divisant toutes les grandeurs de la Fig.2 par la tension stator nominale $V_n$. Il en découle la représentation vectorielle de la Fig.3 a, où $r_a$ et $x_q$ sont respectivement les valeurs reduites de $R_a$ et $X_q$ en utilisant les définitions conventionnelles.

$r_a = R_a/Z_n$

$x_q = X_q/Z_n$

avec

$R_a\,(\Omega) = r_a\,(\%).Z_n$

Ce passage est immédiat en notant les premières expressions :

$$R_a \; \frac{I_n}{V_n} \quad et \quad X_q \; \frac{I_n}{V_n}$$

avec

$$\frac{I_n}{V_n} = \frac{P_n}{3\,V_n^2\cos\varphi_n} = \frac{S_n}{U_n^2} = Z_n^{-1}$$

De la représentation vectorielle en valeurs réduites de la Fig.3, on tire des relations définissant l'angle interne nominal

$\cos\delta_n = (1 + BN)/P_{1n}$ 2.32

et

$\sin\delta_n = AN/P_{1n}$ 2.33

De même, on tire du diagramme de la Fig.2, l'expression de la f.e.m. nominale :

$E_n = E_{1n} - (X_d - X_q)\,I_{1n}$ 2.34

soit

$E_n = E_{1n} + (X_d - X_q) I_n \sin (\delta_n + \varphi_n)$ 2.35

compte tenu de la relation entre courants

$I_l = I \sin (\delta + \varphi)$ 2.36

Le passage aux grandeurs reduites se fait aisément en divisant les termes de l'équation 2.35 par la tension de stator nominale.

On obtient alors :

$\rho_n = \rho I_n + (x_d - x_q) \sin (\delta_n + \varphi_n)$ 2.38

Régime de fonctionnement courant

Pour un point de fonctionnement quelconque indicé 'o', il peut être obtenu à partir de la Fig.2 le même type de diagramme que précédemment en valeurs réduites. Pour cela, il suffit de diviser toutes les grandeurs caractéristiques par la tension de stator courante $V_o$. Le résultat est représenté en b sur la Fig.3.

On aboutit aux relations suivantes définissant l'angle interne

$\sin \delta_o = AN'/\rho_{Io}$ 2.51

$\cos \delta_o = (1 + BN')/\rho_{Io}$ 2.52

En reprenant la même démarche que précédemment, la f.e.m. délivrée par la machine a pour expression

$E_o = E_1 - (X_d - X_q) I_{Io}$ 2.53

On tire de cette expression, l'expression recherchée, soit

$\rho_o = \rho_{Io} + (x_d - x_q)(P_r/V_r^2)(\cos \varphi_n/\cos \varphi_o)$

$\sin(\delta_o + \varphi_o)$ 2.57

Les grandeurs $(h_x - V_o)$ tirées du diagramme de fonctionnement de la machine synchrone présenté à la Fig.1 sont directement proportionnelles aux puissances actives et réactives respectivement.

En effet, ou peut déduire des diagrammes des Fig.1 a 3, les relations suivantes :

$P_o \# h_y 3 V_o/X_q \# 3E_{10} V_o \sin \delta_o/X_q$ 2.73

$Q_o \# (h_x - Y_o) 3 V_o/X_q \# (E_{10} \cos \delta_o - V_o)3V_o/X_q$ 2.74

c) Caractéristiques de réseau

Le réseau de transport est régi par des relations directement tirées du diagramme représenté à la Fig.1, soit :

$X_{rxo} = V_o - R I_x + X I_{yo}$ 2.75

$V_{ryo} = - X I_{xo} - R I_{yo}$ 2.76

dont découle la relation suivante après passage en variables réduites.

$(V_{reso}/V_n) = [(V_{rxo}/V_n)^2 + (V_{ryo}/V_n)^2]^{1/2}$ 2.81

A partir des matrices A, B, C dont la détermination vient d'être décrite, notamment en référence aux diagrammes des Fig.1 a 3, on définit le modèle d'état continu de la machine synchrone.

$d [X(t)] /.dt = A.X(t) + B.U (t)$

$Y(t) = CX(t)$

Puis on calcule des matrices F et G néces saires au logiciel implanté dans le simulateur par les les relations suivantes :

$F = \exp (AT)$

$G = A^{-1} [1 - \exp (AT)] B$

dans lesquelles :

$\exp$ = exponentielle de matrice

$T$ = pas d'échantillonnage

$I$ = matrice unitaire

Le simulateur analogique représenté à la Fig.4 permet la mise en oeuvre du procédé de l'invention jusqu'à l'obtention des matrices A, B et C et du modèle d'état continu de la machine synchrone à simuler.

Il s'agit d'un simulateur analogique du modèle d'état simplifié de la machine.

Ce simulateur comporte deux entrées 1 et 2 auxquelles sont respectivement appliquées les valeurs $- V_{ex}/V_n$ et $-\Delta P_m/P_{mn}$.

L'entrée 1 est connectée par l'intermédiaire d'un organe à gain 3 représentant le coefficient $b_{31}$ de la matrice B qui délivre à sa sortie un signal relié à une entrée d'un intégrateur 4 à quatre entrées. La sortie de l'intégrateur 4 est reliée par l'intermédiaire d'un organe à gain 5 égal à H/100, H étant la valeur du coefficient $b_{22}$ de la matrice B et l'opposé du coefficient $a_{23}$ de la matrice A, à une entrée d'un intégrateur 6 à trois entrées dont une seconde entrée est connectée par l'intermédiaire d'un organe à gain 7 à l'entrée 2 du circuit et dont la sortie est connectée à sa troisième entrée par un organe à gain 8 égal au coefficient D/10, D étant l'opposé du coefficient $a_{22}$ de la matrice A.

La sortie de l'intégrateur 6 est en outre connectée par l'intermédiaire d'un inverseur 9 et d'un organe à gain 10 d'établissement du coefficient $a_{32}$ de la matrice A, à une seconde entrée de l'intégrateur 4. La sortie de cet intégrateur est en outre connectée à une troisième de ses entrées par l'intermédiaire d'un organe à gain 11 d'établissement du coefficient $a_{33}$ de la matrice A. La sortie de l'intégrateur 6 qui délivre un signal correspondant à $\Delta\Omega$ est connectée par l'in termédiaire d'un organe à gain 12 d'établissement du coefficient $-a_{12}$ de la matrice A, à une entrée d'un intégrateur 13 à quatre entrées. Une seconde entrée de l'intégrateur 13 est connectée à la sortie de l'intégrateur 4 par l'intermédiaire d'un organe à gain 14 d'établissement du coefficient $-a_{13}$ de la matrice A. Une troisième entrée de l'intégrateur 13 est connectée à l'entrée 1 du circuit par l'intermédiaire d'un organe à gain 15 d'établissement du coefficient $b_{11}$ de la matrice B. La quatrième entrée de l'intégrateur 13 est connectée à sa sortie par l'intermédiaire d'un organe à gain 16 d'établissement du coefficient $-a_{11}$ de la matrice A.

La sortie de l'intégrateur 13 est en outre reliée à une quatrième entrée de l'intégrateur 4 par l'intermédiaire d'un organe a gain 17 d'établissement du coefficient $-a_{31}$ de la matrice A.

Les intégrateurs entrant dans la construction du circuit de la Fig.4 sont réalisés à partir d'amplificateurs opérationnels.

La sortie de ces intégrateurs simule la variable d'état considérée et leur entrée, sa dérivée, mais de signe opposé car les amplificateurs opérationnels inversent le signe. Les gains ajustables à afficher sont realisés par des potentiomètres linéaires.

Les coefficients D et H intervenant dans les matrices A et B du modèle d'état, étant supérieurs à l'unité, il apparaît des gains de 10 et 100 respectivement sur les entrées des amplificateurs opérationnels intégrateurs concernés. D'autres coefficients sont précédés d'un signe moins car les potentiomètres ne représentent que des gains positifs.

On notera par ailleurs que les deux entrées $\Delta V_{ex}/V_n$ et $\Delta P_m/P_{mn}$ sont négatives afin de respecter le signe des grandeurs de sortie $\Delta V/V_n$, $\Delta\Omega$ et $\Delta P_e/P_n$.

A la sortie de l'intégrateur 13 qui constitue la sortie du simulateur analogique apparaît le signal $\Delta V/V_n$.

A la sortie de l'intégrateur 4 apparaît le signal $\Delta P_e/P_n$.

On voit donc que grâce au circuit qui vient d'être décrit, on obtient à partir du vecteur d'entrée

$$U(t) = \left| \begin{array}{c} V_{ex}(t)/V_{exn} \\ P_m(t)/P_{mn} \end{array} \right|$$

le vecteur d'état

$$X(t) = \left| \begin{array}{c} \Delta V(t)/V_n \\ \Delta \Omega(t) \\ \Delta P_e(t)/P_n \end{array} \right|$$

les trois composantes de ce vecteur apparaissant respectivement aux sorties des intégrateurs 13, 6 et 4.

L'obtention du vecteur Y(t) est assurée par multiplication du vecteur X(t) par la matrice C.

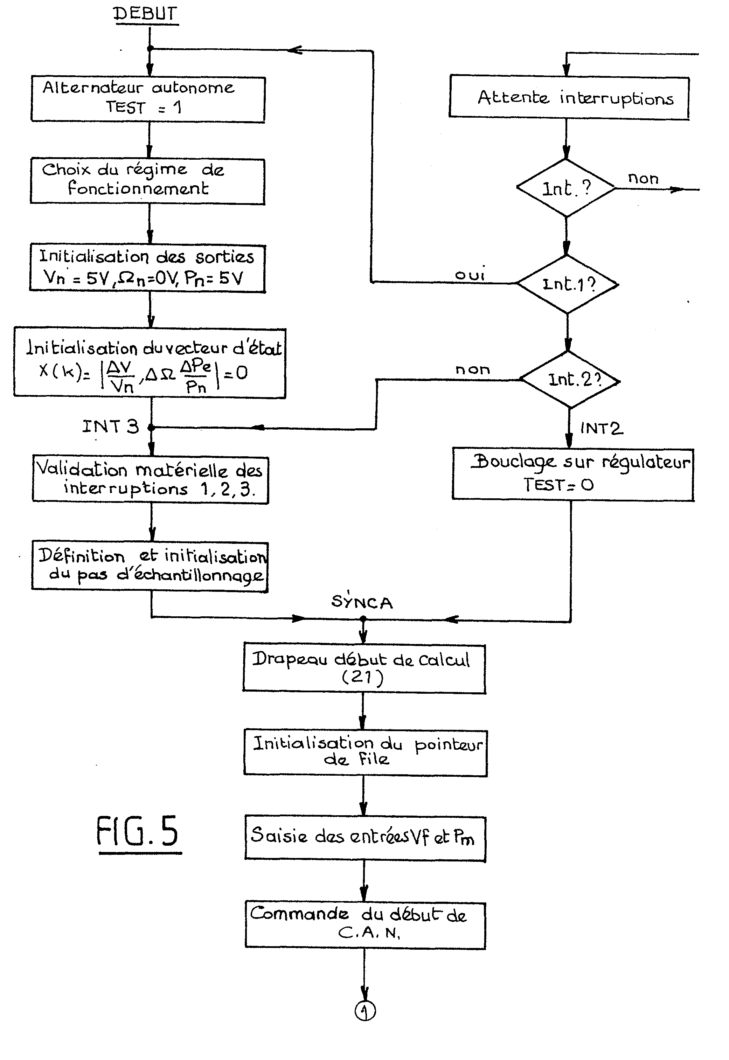

La mise en oeuvre numérique du procédé de simulation suivant l'invention est assurée à l'aide de l'organigramme représenté aux Fig.5 à 7.

Cet organigramme est l'illustration d'un programme implanté dans un micro-processeur à 16 bits par exemple du type TMS9900 de la société Texas Instruments.

Conformément à cet organigramme, on procède tout d'abord comme représenté à la Fig.5, au test de l'alternateur autonome.

Les signaux de test élaborés par le micro-processeur sont notamment le temps de calcul, la visualisation du pas d'échantillonnage, etc.

Ce test étant concluant, on établit le choix du régime de fonctionnement de la machine.

La modulation mathématique décrite plus haut est une modulation du système alternateur-réseau avec de petites variations. Pour réaliser une simulation en vraie grandeur, on doit introduire au niveau des entrées/sorties, les caractéristiques du point de fonctionnement à considérer.

Pour des raisons de compatibilité avec d'autres modèles disponibles, la représentation du régime nominal de la machine synchrone est définie par les valeurs analogiques suivantes.

Tension du stator $V_n = 5V$

Vitesse de l'aire $\Omega_n = 0V$

Puissance électrique $P_{en} = 5V$

Tension d'excitation $V_{fn} = 5V$

Puissance mécanique $P_{mn} = 5V$

Afin de pouvoir simuler des perturbations de grandes amplitudes, il est nécesaire de définir plusieurs points de fonctionnement et de leur associer les valeurs numériques des paramètres du modèle mathématique correspondant.

Seize régimes de fonctionnement sont entrés dans des mémoires mortes associées au microprocesseur.

Leur sélection est assurée par l'intermédiaire d'une molette et d'un interupteur à bascule (non représentés) prévus sur la face avant du simulateur.

Puis on passe a la phase d'initialisation des sorties $V_n = 5V$, $\Omega_n = 0V$, $P_n = 5V$ et au cours de la phase suivante, à l'initialisation du vecteur d'état $X(k) = |\Delta V/V_n, \Delta\Omega, \Delta P_e/P_n| = 0$.

La phase suivante est la validation d'interruption 1,2 et 3 sur lesquelles on reviendra par la suite.

Ensuite, on procède à la définition et à l'initialisation du pas d'échantillonnage.

Puis après une phase de drapeau de début de calcul et d'initialisation du pointeur de file, on procéde à la

saisie des entrées Vf et Pm représentant U(k).

Interviennent ensuite les opérations de commande de la conversion analogique-numérique des données d'entrée.

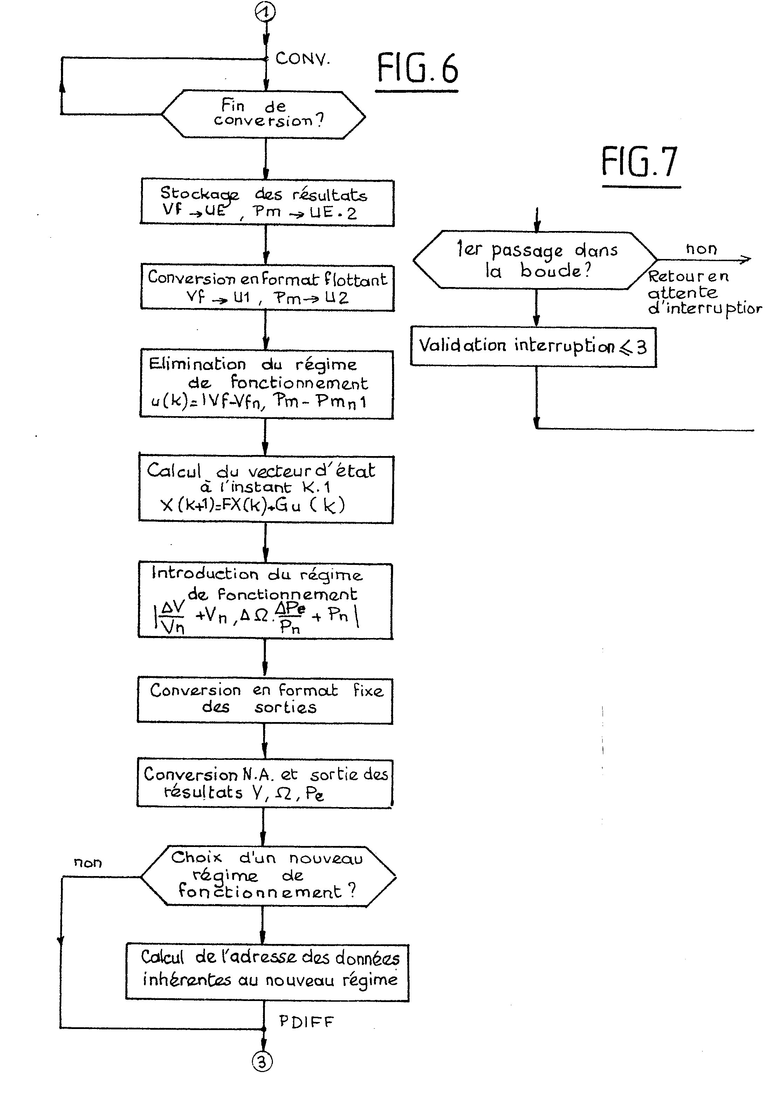

La suite des opérations est illustrée à la Fig.6 sur laquelle on voit la phase de conversion analogique-numérique et le contrôle de la fin de conversion.

Les résultats de la conversion à savoir $V_f \rightarrow$ UE et $P_m \rightarrow$ UE + 2 sont stockés en mémoire.

Les données stockées sont converties en format flottant $V_f \rightarrow U_1$, $P_m \rightarrow U_2$.

La phase suivante consiste en l'élimination du régime de fonctionnement par suppression de la composante continue pour obtenir :

$u(k) = |V_f - V_{fn}\ P_m - P_{mn}|$

Ensuite, on calcule le vecteur d'état a l'instant k + 1 X(K+1) = FX(k) + Gu(k)

Au cours de la phase suivante, on procéde à l'introduction du régime de fonctionnement en rajoutant à nouveau la composante continue :

$$\left| \frac{\Delta V}{V_n} + V_n , \Delta \Omega , \frac{\Delta Pe}{P_n} + P_n \right|$$

Les sorties obtenues sont alors converties en revenant au format entier à partir du format flottant.

Ensuite, on convertit en analogique les valeurs numériques des résultats de l'opération précédentes pour obtenir les valeurs de V, $\Omega$ et Pe.

Cette opération est suivie éventuellement par une interrogation relative au choix d'un nouveau régime de fonctionnement.

Si la réponse est oui, on procéde au calcul de l'adresse des données internes au nouveau régime.

Si la réponse est non, on passe directement à la phase drapeau de fin de calcul de la Fig.7.

Cette phase est suivie d'une interrogation relative au premier passage dans la boucle.

Dans l'affirmative, il y a validation d'interruption tant que l'indice d'interruptions est inférieur ou égal à 3.

Dans le cas contraire, il y a retour en attente d'interruption (Fig.5).

On parvient ainsi a simuler le fonctionnement de la machine synchrone a partir des divers régimes de fonctionnement stockés en mémoire et adressés successivement au cours de l'éxecution du programme.

## Revendications

1. Procédé de simulation d'une machine électrique synchrone, caractérisé en ce qu'il consiste à mesurer des paramètres physiques particuliers choisis d'une machine tournante synchrone, à combiner ces paramètres avec des variables définissant le régime nominal de la machine, à obtenir à partir desdits paramètres physiques et desdites variables un jeu de coefficients des première matrices (A,B,C) de représentation d'état continu de la machine et à obtenir à partir de ces matrices un système d'équations d'état continu de la machine :

$d\ /X(t)/\ /dt = A.X.\ (t) + B.U.(t)$

$Y(t) = C.X(t)$

dans lequel

X(t) est le vecteur d'état du système, dont la première composante $\Delta V(t)/V_n$ représente à l'instant t les variations relatives de la tension du stator, dont la deuxième composante $\Delta\Omega(t)$ représente les variations de la vitesse de la machine synchrone et dont la troisième composante $\Delta Pe(t)/P_n$ représente les variations relatives de la puissance électrique;

U(t) est le vecteur d'entrée du système dont la première composante $\Delta V_{ex}(t)/V_{exn}$ représente les variations relatives de la tension d'excitation de la machine, et dont la deuxième composante $\Delta P_m(t)/P_{mn}$ représente la variation relative de la puissance mécanique appliquée à la machine;

Y(t) est le vecteur de sortie du système, dont la première composante $\Delta\delta'(t)$ représente les variations d'angle interne total entre la tension du réseau et la f.e.m. de la machine, dont la deuxième composante $\Delta Q_e(t)/Q_n$ représente les variations rela tives de la puissance réactive dont la troisième composante $\Delta I(t)/I_n$ représente les variations relatives du courant du stator et dont les quatrième et cinquième composantes $\Delta\delta(t)$ et $\Delta\Psi(t)$ représentent respectivement les variations de l'angle interne entre la tension du stator et la f.e.m. de la machine et les variations de l'angle de transport entre la tension du stator et la tension du réseau.

2. Procédé suivant la revendication 1, de simulation numérique d'une machine électrique synchrone, caractérisé en ce qu'à partir des coefficients des premières matrices (A,B,C) de représentation d'état continu de la machine, on procéde à l'établissement de secondes matrices (F,G,C) nécessaires à l'établissement des relations d'état et de sortie de la machine à simuler, en convertissant les premières matrices en des relations cohérentes avec le traitement numérique et on combine ces relations pour obtenir un système d'équations d'état discontinu ou échantillonné :

$$X(k) = FX(k-1) + Gu(k-1)$$

$$Y(k) = CX(k)$$

dans lesquelles k représente les instants d'échantillonnage des données d'entrée et d'état.

3. Simulateur analogique pour la mise en oeuvre du procédé suivant la revendication 1, caractérisé en ce qu'il comporte des moyens (3,5,7,8,10,12, 15,16,17) pour engendrer des signaux correspondant aux coefficients desdites matrices (A,B) et des moyens (4,6,13) pour engendrer en réponse aux signaux d'entrée ( $\Delta$ Vex/Vn et $\Delta$ Pm/Pm) correspondant aux composantes du vecteur d'entrée du système et des signaux correspondant aux coefficients des matrices (A,B) des signaux de sortie correspondant respectivement aux composantes ( $\Delta$ Pe/Pn, $\Delta\Omega$ , $\Delta$ V/Vn) du vecteur de sortie du système.

4. Simulateur suivant la revendication 3, caractérisé en ce que lesdits moyens (3,5,7,8,10,12, 15,16,17) pour engendrer lesdits signaux correspondant aux coefficients desdites premières matrices (A,B) sont constitués par des organes à gain tels que des potentiomètres et en ce que lesdits moyens (4,6,13) pour engendrer lesdits signaux correspondant aux composantes du vecteur de sortie sont constitués par des intégrateurs.

5. Procédé suivant l'une des revendications 1 et 2, caractérisé en ce qu'il est mis en oeuvre à l'aide d'un programme d'ordinateur.

FIG.1

FIG.2

0241368

FIG.3A

FIG.3B

FIG.3

FIG.4

U241368

DEBUT

```
┌──────────────────────┐              ┌──────────────────────┐
│ Alternateur autonome │              │ Attente interruptions│
│      TEST = 1        │              └──────────────────────┘
└──────────────────────┘
```

┌──────────────────────┐
│ Choix du régime  de  │
│   fonctionnement     │
└──────────────────────┘

Int. ?  ── non ──►

┌──────────────────────┐
│ Initialisation des sorties │
│ Vn = 5V, Ωn=0V, Pn= 5V │
└──────────────────────┘

oui ──  Int.1?

┌──────────────────────────┐
│ Initialisation du vecteur d'état │
│ X(k)= |ΔV/Vn, ΔΩ ΔPe/Pn| = 0 │
└──────────────────────────┘

non ──  Int.2?

INT 3

┌──────────────────────┐          INT2
│ Validation matérielle des │      ┌──────────────────────┐
│ interruptions 1,2,3. │          │ Bouclage sur régulateur │
└──────────────────────┘          │      TEST = 0        │
                                   └──────────────────────┘

┌──────────────────────┐
│ Définition  et initialisation │
│ du pas d'échantillonnage │
└──────────────────────┘

SYNCA

┌──────────────────────┐
│ Drapeau début de Calcul │
│         (21)         │
└──────────────────────┘

┌──────────────────────┐
│ Initialisation du pointeur │
│      de File         │
└──────────────────────┘

┌──────────────────────┐
│ Saisie des entrées Vf et Pm │
└──────────────────────┘

┌──────────────────────┐
│ Commande  du début de │
│      C.A. N.         │
└──────────────────────┘

FIG. 5

①

0241368

## FIG.6

① CONV.

Fin de conversion?

Stockage des résultats
Vf → UE , Pm → UE.2

Conversion en format flottant
Vf → U1 , Pm → U2

Elimination du régime
de fonctionnement
$u(k) = |Vf - Vf_n, Pm - Pm_n|$

Calcul du vecteur d'état
à l'instant K.1
$X(k+1) = FX(k) + Gu(k)$

Introduction du régime
de fonctionnement
$|\frac{\Delta V}{V_n} + V_n, \Delta \Omega \cdot \frac{\Delta Pe}{P_n} + P_n|$

Conversion en format fixe
des sorties

Conversion N.A. et sortie des
résultats $V, \Omega, Pe$

Choix d'un nouveau
régime de
fonctionnement ?   non

Calcul de l'adresse des données
inhérentes au nouveau régime

PDIFF

③

## FIG.7

1er passage dans
la boucle ?   non
Retour en
attente
d'interruption

Validation interruption $\leqslant 3$

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | IEEE TRANSACTIONS ON POWER APPARATUS AND SYSTEMS, vol. PAS-103, no. 3, mars 1984, pages 516-521, IEEE, New York, US; A. KEYHANI et al.: "Development of an interactive power system research simulator" <br> * Page 518, colonne de gauche, ligne 1 - colonne de droite, ligne 4; page 520, colonne de droite, lignes 1-13 * | 1,5 | G 06 F 15/60 <br> G 06 G 7/63 |
| | --- | | |
| A | PROCEEDINGS OF THE IEEE, vol. 67, no. 10, octobre 1979, pages 1428-1439, IEEE, New York, US; J.G. KASSAKIAN: "Simulating power electronic systems - A new approach" <br> * Page 1428, colonne de droite, lignes 12-32; page 1431, chapitre: "Analog computer solution", alinéas 1,2 * | 1,3-5 | |
| | ----- | | |

DOMAINES TECHNIQUES RECHERCHES (Int. Cl.4)

G 06 F 15/60
G 06 G 7/63

Le présent rapport de recherche a été établi pour toutes les revendications

| Lieu de la recherche | Date d'achèvement de la recherche | Examinateur |
|---|---|---|
| LA HAYE | 14-07-1987 | SONIUS M.E. |